# EUROPÄISCHE PATENTANMELDUNG

(11) **EP 1 876 646 A2**
(43) Veröffentlichungstag der Anmeldung: **09.01.2008**
(21) Anmeldenummer: 07405190.5
(22) Anmeldetag: 03.07.2007
(51) Int. Cl.: H01L 25/16, H01L 33/00

(54) **LED-Leuchte**

(30) Priorität: 07.07.2006 DE 102006031835
(71) Anmelder: Rütsche Technik GmbH, 9602 Bazenheid (CH)
(72) Erfinder: Rütsche, Gallus, 9602 Bazenheid (CH)
(74) Vertreter: Barth, Carl Otto

(57) **Zusammenfassung**

Die Erfindung betrifft eine LED-Leuchte (5) mit integrierter Elektronik (7) zur Ansteuerung der LED (6). Eine solche Leuchte kann für beengte Raumverhältnisse, z.B. Kücheneinrichtungen, oder für wärmeempfindliche, feuchte, oder schmutzige Umgebungen, z.B. Käfige oder Stallungen, verwendet werden, da sie sehr robust und unempfindlich gegen Feuchtigkeit, Schmutz oder Vibrationen ist. Eine Ausführungsform gestattet das einfache Einklicken (snap-on) einer Trägerplatte (8), die sowohl die LED (6) als auch deren Steuerelektronik (7) trägt, in ein Gehäuse (11) mit nachfolgendem Vergiessen, was die LED-Leuchte (5) wasserdicht und unempfindlich gegen äussere Einflüsse macht.

## Beschreibung

Die Erfindung betrifft eine Leuchte für die Beleuchtung von Räumen, in denen eine kompakte, in sich geschlossene, kompakte, einfach zu handhabende und Platz sparende Leuchte bzw. ein derartiger Leuchtkörper erforderlich oder zweckentsprechend ist. Sie ist insbesondere für belastete Umgebungen, z.B. Feuchträume oder Tierzucht- und Tiermast-Anlage verwendbar, kann aber auch in gewöhnlichen, keinen besonderen Belastungen ausgesetzten Räumen eingesetzt werden.

Es ist oft sinnvoll und manchmal notwendig, Kunstlicht mit einem kompakten Leuchtkörper mit wenig Stromverbrauch (und wenig Wärmeerzeugung) zu erzeugen, wobei es oft erwünscht ist, Leuchtkraft, Leuchtdichte oder Lichtmenge regeln zu können. Eine kompakte, Platz sparende Leuchte, die alle Bauteile in sich vereinigt, ist in solchen Fällen vorteilhaft.

Herkömmliche Leuchtmittel, z. B. Glühlampen, Sparlampen mit W14- oder W27-Fassungen, welche im Leistungsbereich von 7 und mehr Watt liegen, sind deswegen für die Beleuchtung der oben erwähnten Räume und Anlagen nicht ideal, weil ihre Fassungen und Gehäuse viel Platz beanspruchen und dazu oft gegen Schmutz und/oder Feuchtigkeit aufwendig geschützt werden müssen. Ausserdem sind viele herkömmliche Leuchtmittel relativ kurzlebig und reagieren empfindlich auf Vibrationen und Regelung (Dimmen). Insbesondere Sparlampen, die üblicherwesie als Quecksilber-Neiderdrucklampen ausgeführt sind, lassen sich nur mit erheblichem Aufwand dimmen.

So ist es beispielsweise bekannt, dass sich die Produktivität von in Stallungen oder Käfigen gehaltenen Tieren durch eine gesteuerte Beleuchtung erhöhen lässt. Eine entsprechend ausgestaltete Anlage für die Hühnerhaltung mit Einzelleuchten, also sozusagen mit "lokaler" Beleuchtung, ist in der WO-Publikation WO 98/11946 dargestellt und beschrieben. Zwar wird die Verwendung von LEDs (Light Emitting Diodes) erwähnt, über die Gestaltung der eigentlichen Leuchte ist aber nichts gesagt.

In der europäischen Patentanmeldung EP 1 477 729 ist eine Beleuchtungsvorrichtung für Geflügel-Haltungsanlagen beschrieben, bei der ebenfalls einzelne Leuchten in den verschiedenen Etagen eines Geflügelkäfigs benutzt werden. Als Leuchtmittel werden hier ebenfalls LEDs benutzt. Handelsübliche LEDs benötigen allerdings Versorgungsspannungen zwischen etwa 5 und 30 Volt Gleichstrom, wofür entsprechende Vorschalt- und Steuergeräte vorgesehen sein müssen. Sollen die LEDs steuerbar sein, z.B. in ihrer Helligkeit, sind weitere elektrische Bauteile nötig. Die in solchen Vorschalt- und Steuergeräten vorhandenen elektrischen Bauteile wie Transformatoren und Gleichrichter sind in einem Geflügelkäfig natürlich besonderen Belastungen durch Schmutz und Feuchtigkeit ausgesetzt. Dazu liefert die genannte EP 1 477 729 keine Lösung. Auch ist über eine Steuerelektronik, die sich für eine sinnnvolle Nutzung der mittels LEDs gegebenenen Möglichkeiten anböte, nichts gesagt.

Aber auch in weniger kritischen Umgebungen ist eine kompakte, in sich geschlossene LED-Leuchte, die die erforderlichen Bauelemente für die Versorgung und die Regelung der als Leuchtmittel verwendeten LED enthält, aber dennoch wirtschaftlich hergestellt werden kann, von grossem Vorteil.

Bei der Verwendung von LEDs kann die Erzeugung der notwendigen Niederspannung in vorteilhafter Weise für eine Mehrzahl von LEDs zusammengefasst werden. Dann lassen sich die üblicherweise zur Erzeugung der erforderlichen Niederspannung verwendeten Transformatoren getrennt unterbringen und die Zuleitungen zu den LED-Leuchten führen nur ungefährliche Niederspannung.

Aufgabe der Erfindung ist es daher, eine auch unter normalen wie auch schwierigen Umgebungsbedingungen brauchbare, einfach und sicher verwendbare Leuchte zu schaffen, die dazu noch preiswert in grosser Stückzahl hergestellt werden kann, wobei die Langlebigkeit der als Leuchtmittel benutzten LEDs voll genutzt werden soll. M.a.W., es soll eine möglichst universell verwendbare Leuchte geschaffen werden, die klein und kompakt ist, unempfindlich gegen Schmutz, Feuchtigkeit und Vibrationen ist, dazu geringen Stromverbrauch aufweist und mit sicherer Niederspannung zu betreiben und dazu noch einfach herzustellen ist.

Zur Lösung dieser Aufgabe ist eine LED-Leuchte entsprechend dem Patentanspruch 1 ausgebildet. Der Leuchtkörper für Bauelemente und Systeme ist Gegenstand des Patentanspruches XX

Die Erfindung verwendet als Leuchtmittel Hochleistungs-LEDs, die derzeit mit bis zu 5 Watt Leistung angeboten werden. Solche LEDs sind findet man heute in vielen Beleuchtungsanwendungen, wobei, wie oben beschrieben, die Steuer-und Regelelektronik getrennt, z.B in separaten Gehäusen, untergebracht ist.

Im Prinzip beruht die Erfindung auf der Idee, alle für die Steuerung der LED notwendigen Komponenten auf einem einzigen Print (einer gedruckten Schaltung oder einer Platine), auf dem vorzugsweise auch das Leuchtmittel, die LED, befestigt ist, zu integrieren und diesen Print mittels einer einfachem Snap-in Methode oder in ähnlich einfacher Weise in einem entsprechend gestalteten Gehäuse zu montieren. Dies kann anschliessend vergossen oder auf andere Weise abgedichtet werden. Dadurch sind die Nachteile der derzeitig auf dem Markt befindlichen LED-Leuchten behoben.

Alternativ kann auch der Print bzw. die Platine mit der montierten LED ohne Verwendung eines Gehäuses in Kunstharz vergossen werden, womit, durch den Wegfall des Gehäuses, eine sehr preiswerte und kompakte Leuchte entsteht.

Eine solche Leuchte mit integrierter Steuerelektronik bietet weiterhin eine Vielzahl elektrischer Anschlussmöglichkeiten, z.B. die integrierte Befestigung und Stromzuführung mittels werkzeugloser Verbindung mit isoliertem Drahtseil, wie es heute für Innenraumbeleuchtung Mode ist. Hier können integrierte Schneidklemmen, Schraubklemmen, Stahlstifte oder isolierte Drahtenden verwendet werden.

Zudem bietet eine LED-Leuchte mit integrierter Steuerelektronik gemäss der Erfindung den Vorteil, dass praktisch jegliche Gehäuseform bzw. Raumform realisiert werden kann, wobei ästhetisch ansprechende Lösungen erarbeitet werden können.

Die weiteren Vorteile sind der geringe Energieverbrauch und die geringe Erwärmung von LED-Leuchten im Vergleich zu Leuchten, die mit Glühlampen bestückt sind, dazu kommt die ausserordentliche Kompaktheit, der hohe Wirkungsgrad, grosser Farbenvielfalt, lange Lebensdauer, und schliesslich die Unempfindlichkeit gegen Vibrationen, Schmutz und Feuchtigkeit.

Die Erfindung bietet zudem einen wirtschaftlichen Vorteil. Obwohl Hochleistungs-LEDs teurer sind als herkömmliche Leuchtmittel, führt der geringere Stromverbrauch in kurzer Zeit zur Amortisation der grösseren Anschaffungskosten. Hinzu kommt die lange Lebensdauer der Leuchtmittel, die ein Vielfaches gewöhnlicher Glühlampen und immer noch ein Mehrfaches von handelsüblichen Stromsparlampen beträgt. Da in vielen Anwendungsbereichen das Wechseln einer Leuchte oder Lampe mit erheblichem Aufwand verbunden ist, lassen sich hier weitere Kosten einsparen.

Durch ihre kompakte Bauweise und wegen ihres geringen Gewichts können die LED-Leuchten gemäss der Erfindung einfacher montiert werden als herkömmliche Leuchten. So ist neben Schraubverbindungen auch das Kleben oder eine Befestigung mittels Clips oder ähnlicher Vorrichtungen möglich. Wie oben erwähnt erfolgt die Verkabelung im Niederspannungbereich, womit eine Gefährdung von Mensch und Tier gering gehalten wird.

Anhand der nachfolgenden Beschreibung von Ausführungsbeispielen im Zusammenhang mit den Zeichnungen wird die Erfindung näher erläutert. In den Zeichnungen zeigen:
- Fig. 1: einige Leuchten herkömmlicher Bauart und ihre Anwendung;
- Fig. 2: eine Leuchte gemäss der Erfindung und ihre Anwendung;
- Fign. 3a, 3b: Schnittzeichnungen durch zwei Ausführungsformen einer Leuchte gemäss der Erfindung;
- Fig. 4: eine Platine mit darauf angeordneter LED gemäss der Erfindung;
- Fig. 5: ein Beispiel für die elektrische Schaltung zum Betrieb einer LED;
- Fign. 6a-6c: Beispiele für verschiedene verwendbare Gehäuseformen; und
- Fig. 7: ein Schaltungsbeispiel für die Erzeugung der Niederspannung und die Regelung/Dimmung von LED-Leuchten.

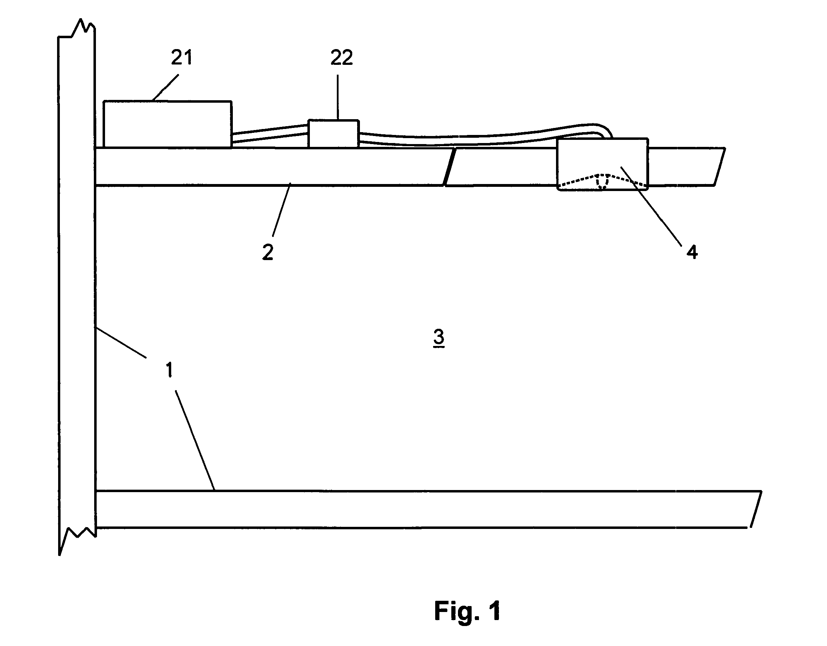

Fig. 1 zeigt die übliche Anordnung einer Leuchte 4 zur Beleuchtung eines Raums 3 mit mehreren Etagen 2 in einem Gestell 1, wie sie z.B. gemäss dem Stand der Technik zur Beleuchtung von Geflügelkäfigen benutzt wird. Leuchte 4 und Steuerelektronik 22 sind getrennt; dies ergibt neben einem gewissen Platzbedarf auch eine elektrische Unsicherheit wegen der Vielzahl von erforderlichen elektrischen Verbindungen. Die Stromversorgungseinheit 21 ist derlichen elektrischen Verbindungen. Die Stromversorgungseinheit 21 ist in der Nähe von Leuchte 4 und Steuerelektronik 22 angeordnet. Bei dieser Anordnung können üblicherweise nur eine beschränkte Anzahl LEDs pro Steuerelektronik 22 angesteuert werden.

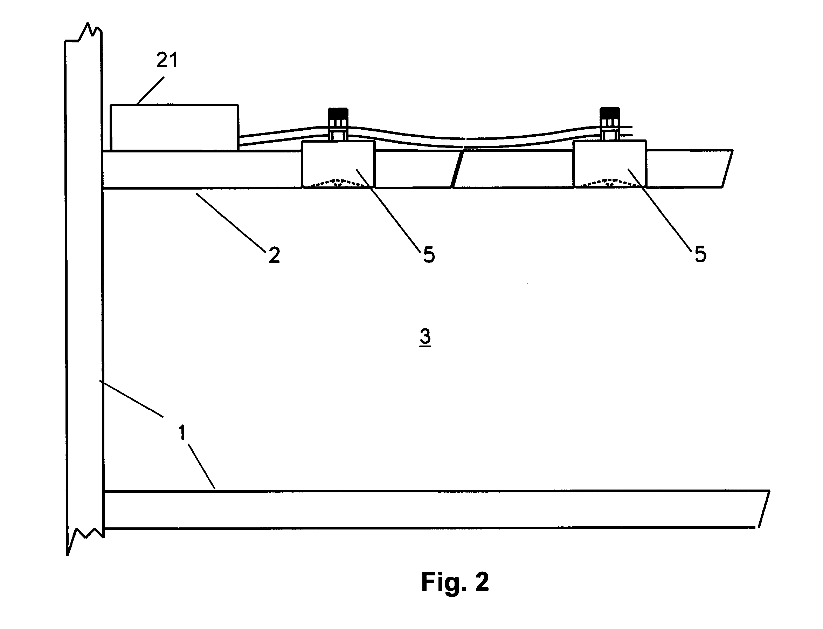

Fig. 2 zeigt demgegenüber eine Anordnung, wie sie mittels der erfindungsgemässen Leuchte 5 möglich wird. Gestell 1 mit den Etagen 2 und dem zu beleuchtenden Raum 3 sind unverändert gegenüber der in Fig. 1 dargestellten Anordnung. Durch die Kompaktheit der Leuchte 5 und die Integration der Steuerelektronik in die Leuchte und den dadurch verringerten Platzbedarf können z.B. zwei Leuchten 5 im prinzipiell gleichen Raum wie in Fig. 1 angeordnet werden, so dass eine bessere Ausleuchtung des Raums 3 ermöglicht wird. Auch lassen sich die Leuchten gemäss der Erfindung bei beengten Platzverhältnissen einbauen. Die Leuchten 5 werden von einer zentralen Stromversorgung 21 elektrisch versorgt; allein deren Leistung - nicht der Platzbedarf der Leuchten - bestimmt die Anzahl der anschliessbaren Leuchten. Die Ansteuerung der Leuchten kann zentral erfolgen; die Steuerelektronik ist gemäss der Erfindung aber in jede Leuchte integriert.

Fig. 3a zeigt den inneren Aufbau einer erfindungsgemässen Leuchte 5. Als Leuchtmittel wird eine Hochleistungs-LED 6 verwendet. Diese befindet sich auf der einen Seite der Trägerplatte 8, die auch als Kühlkörper dienen kann. Auf der anderen Seite der Trägerplatte 8 ist die Steuerelektronik 7 mit Klemmen 10 für die Stromzuführung angeordnet. Das Gehäuse 11 der Leuchte 5 ist hier einteilig ausgeführt. Nach dem Einbau der Teile wird das Gehäuse 11 mit einer Vergussmasse 9 ausgegossen, die ein guter Wärmeleiter und/oder resistent gegen Feuchtigkeit ist.

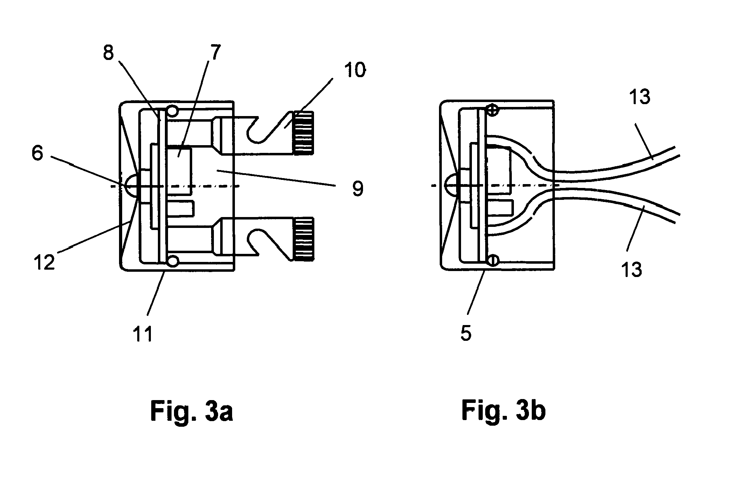

Fig. 3b zeigt andere Ausführungsform einer erfindungsgemässen Leuchte 5. Der Unterschied zur Leuchte der Fig. 3a besteht darin, dass die Stromzuführung über Kabel 13 und nicht über Klemmen erfolgt. Der restliche Aufbau ist unverändert.

Das Gehäuse 11 kann in praktisch beliebigen Formen ausgeführt werden, wobei als Material wegen der geringen Wärmeentwicklung sowohl Metalle als auch andere Materialien, z.B. Kunststoffe, zum Einsatz kommen können. Bei letzteren muss auf eine gewisse Wärmeleitfähigkeit geachtet werden, da LEDs als Halbleiterbauelemente wärmeempfindlich sind und einer gewissen Kühlung bedürfen. Durch das Ausgiessen des Gehäuses mit entsprechender Vergussmasse 9 wird die Leuchte 5 wasserdicht. An der Vorderseite kann die Leuchte 5 einen Reflektor 12 aufweisen, der mittig eine Öffnung für die LED aufweist.

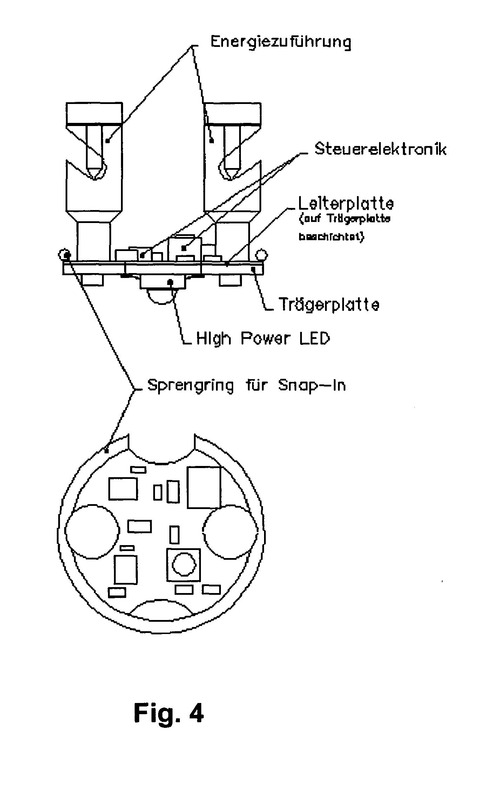

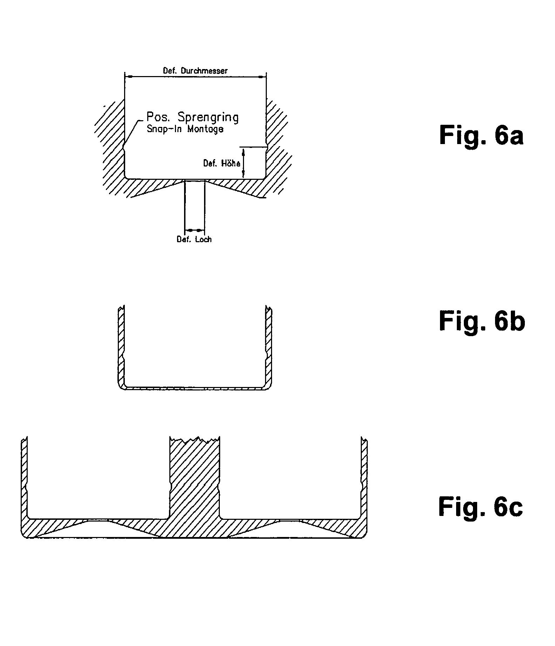

Fig. 4 zeigt eine weitere Trägerplatte (auch Print oder Platine genannt) mit darauf angeordneter Steuerelektronik für den Betrieb der ebenfalls auf der Trägerplatte angebrachten Hochleistungs-LED. Die gezeigte Trägerplatte ist für eine Befestigung mittels eines Sprengrings in einem Gehäuse, wie es z.B. in den Figuren 3a, 3b und in den Figuren 6a bis 6c gezeigt ist, geeignet. Dieser Sprengring kann als Teil der Trägerplatte ausgebildet, quasi in die Trägerplatte intergriert sein. Die elektrischen Anschlüsse sind hier wieder als Klemmen ausgebildet, wie sie bereits in Fig. 3a gezeigt sind. Natürlich kann diese Trägerplatte auch ohne Verwendung eines Gehäuses unmittelbar mit Kunstharz ummantelt werden, wobei einerseits der Lichtaustritt, andererseits die Wärmeableitung gesichert sein müssen.

Bei der in Fig. 4 gezeigten Ausführungsform ist die LED auf einer Seite (Unterseite) der eigens für diese Leuchtentechnik entwickelten Trägerplatte, die z.B. aus Aluminium bestehen kann, angebracht. Auf der gegenüberliegenden Seite (Oberseite) der Trägerplatte ist die Steuerelektronik angeordnet, wobei in der gezeigten Ausführungsform die Trägerplatte mit einer speziellen Schicht als Leiterplatte für die Elektronik beschichtet wird und die Stromzuführungen ebenfalls auf dieser Seite integriert ist. Die Unterseite kann bei genügender Wärmeableitung auch mit mehr als einer LED bestückt werden.

Wie oben bereits angedeutet, kann die Trägerplatte, die bis auf ein Gehäuse bzw. eine Ummantelung eine in sich komplette Leuchten-Einheit darstellt, mittels des (integrierten) Sprengrings in eine definierte Öffnung eines geeigneten Gehäuses eingesetzt und ggf. vergossen werden. Alternativ kann die Trägerplatte mit den daruf angeordneten Bauteilen mit Kunststoff/Kunstharz umgossen werden, womit sich nahezu beliebige Körperformen realisieren lassen.

Die Steuerelektronik auf der Oberseite der Trägerplatte kann z.B. folgende Funktionen ausführen:
- Regelung (Dimmen) der LED (mittels Spezial-IC);
- Konstantstrom-Regelung
- Gleichrichtung und Regelung der Versorgungsspannung für die LED.

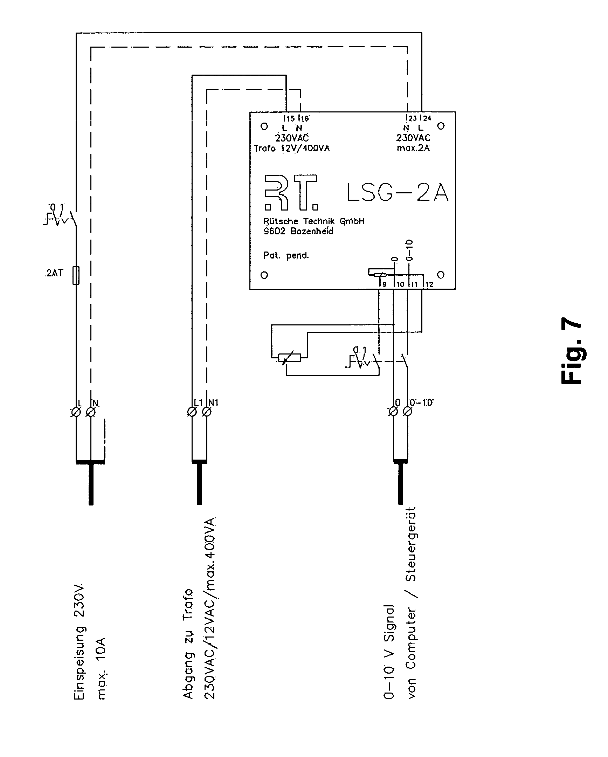

Die Spannungsversorgung der LED-Leuchte erfolgt im ungefährlichen Niedervoltbereich mittels Gleich- oder Wechselspannung durch eine externe Stromversorgungseinheit, die auch eine Regelschaltung für die Dimmung der LED-Leuchte(n) aufweisen kann. In Fig. 7 ist ein Beispiel für eine solche "externe" Versorgungseinheit gezeigt. Die Steuerelektronik in der LED-Leuchte muss natürlich entsprechend ausgelegt bzw. angepasst werden. Alternativ ist auch eine sich automatisch anpassende Eingangsschaltung auf der Trägerplatte realisierbar, wodurch sich eine universell verwendbare LED-Leuchte ergibt.

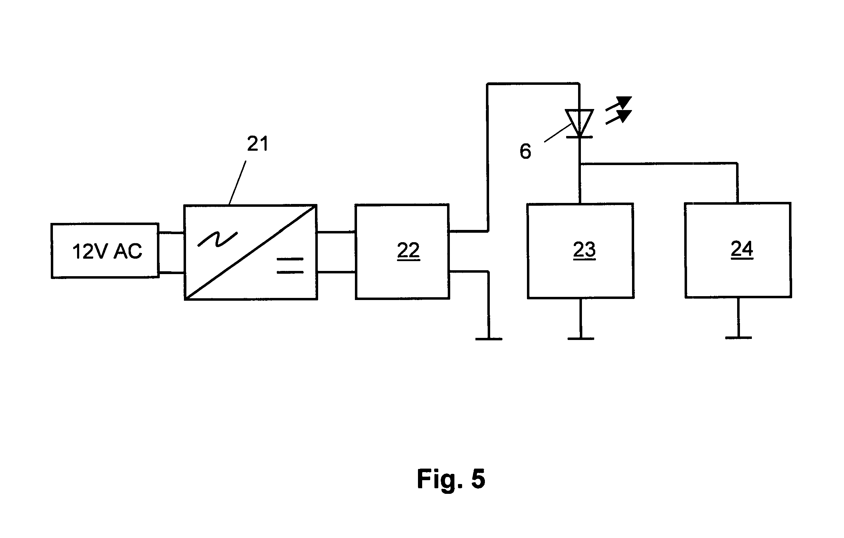

In Fig. 5 ist beispielhaft eine Steuerelektronik zum Betrieb einer LED dargestellt, wie sie für die Erfindung verwendet werden kann. Die Versorgungsspannung beträgt im gezeigten Beispiel 12 V =, also eine auch unter kritischen Bedingungen ungefährliche Spannung. Ein Gleichrichter 21 versorgt über einen Filter 22 die Leuchtdiode 6. Weiterhin sind zum Betrieb der LED eine Strombegrenzerschaltung 23 und ein Niedrig-Spannungs-Bypass 24 vorgesehen.

Mit der Schaltung wird die über die Eingangsklemmen zugeführte Versorgungsspannung von 12 V = an die Betriebs-Gleichspannung der LED angepasst bzw. heruntergeregelt. Handelsübliche Hochleistungs-LEDs werden meist mit einem konstanten Gleichstrom betrieben, der mittels des gezeigten Schaltung erzeugt und geregelt wird. Stufenloses Dimmen kann beispielsweise mittels einer Phasenanschnitt-Regelung der Versorgungsspannung (im gezeigten Beispiel 12 V =) erfolgen. Dadurch kann die LED bis auf Null geregelt werden.

Wenn in einer Leuchten-Einheit mehrere LEDs angeordnet sind (s. Fig. 6c), können diese vorzugsweise von einer gemeinsamen Steuerelektronik angesteuert werden, wodurch sich eine kompakte und wirtschaftliche Konstruktion ergibt.

Die Figuren 6a bis 6c zeigen verschiedene Gehäuseformen, wie sie für die Erfindung verwendet werden können. In Fig. 6a ist eine massives, dickwandiges Gehäuse dargestellt, das eine Bohrung mit einem definierten Durchmesser aufweist. Dieser Durchmesser ist minimal grösser als der Durchmesser einer dazu passenden Trägerplatte, wie sie in Fig. 4 dargestellt ist. Beim Einsetzen dieser Trägerplatte schnappt der vorgesehene Sprengring in die entsprechende Aussparung der Gehäusewand und hält damit die Trägerplatte definiert und unverrückbar in der vorgesehenen Position.

Fig. 6b zeigt eine ähnliche, aber dünnwandige Ausführungsform wie Fig. 6a. In Fig. 6c schliesslich ist ein Gehäuse for eine Doppel-Leuchte dargestellt. Darin können einerseits zwei unabhängige, ggf. auch unabhängig regelbare Leuchten, sprich Trägerplatten mit LEDs, untergebracht werden. Andererseits kann auch nur eine Steuerelektronik (auf einer ersten Trägerplatte) vorgesehen sein, die beide LEDs ansteuert, wobei die LEDs vorzugsweise in Serie geschaltet sind. Die zweite Trägerplatte weist dann nur eine LED mit den entsprechenden Anschlüssen auf und keine Steuerelektronik. Die Befestigung der beiden Trägerplatten erfolgt wie in Fig. 6a.

Die Integration der Schaltung bzw. Steuerelektronik in die Leuchte selbst ist vorteilhaft, weil die LED nicht durch eine externe Schaltung betrieben werden muss, womit Fehler- und Störquellen durch die bisher verwendeten Drahtverbindungen ausgeschlossen werden. Die Integration der gezeigten Schaltung und der LED benötigt keine weiteren Anschlüsse als die Energiezuführungen und ergeben eine elektrische Einheit, die - bis auf die Stromzufuhr - ohne externe Beschaltung auskommt und damit als funktionstüchtige Einheit getestet und betrieben werden kann.

In Fig. 7 ist beispielhaft die Schaltung einer externen Versorgungseinheit zum Betrieb einer oder vorzugsweise mehrerer LED-Leuchten dargestellt. Werden mehrere LED-Leuchten verwendet, so können diese in Reihe geschaltet werden, was den Verdrahtungsaufwand gering hält. Natürlich muss die Leistung der Versorgungseinheit der Anzahl und Leistung der zu speisenden LED-Leuchten entsprechen. Die Eingangsspannung der gezeigten Versorgungseinheit beträgt 230 V =, die Ausgangsspannung 12 V =. Diese Ausgangsspannung ist per Phasenanschnitt regelbar und erlaubt das Dimmen der angeschlossenen LED-Leuchte(n). Die Ansteuerung dieser Ausgangsspannungsregelung erfolgt mittels eines Gleichspannungssignals von 0 - 10V von einer (nicht gezeigten) Steuereinheit, z.B. einem Computer, oder einfach mittels eines an der Versorgungseinheit angeordneten Drehknopfs zu manuellen Steuerung.

## Patentansprüche

1. LED-Leuchte (5) mit wenigstens einer LED (6),
***dadurch gekennzeichnet,***
- **dass** die LED (6) und eine Steuerelektronik für die LED (6) auf einer gemeinsamen Platine oder Trägerplatte (8) angeordnet sind,
- **dass** nach aussen führende Anschlüsse (10, 13) für die Stromversorgung auf der Trägerplatte (8) vorgesehen sind,
- **dass** die LED (6), die Steuerelektronik, die Trägerplatte (8) und die Anschlüsse (10, 13) in einem gemeinsamen Gehäuse (11) angeordnet oder mit Kunststoff ummantelt sind.

2. LED-Leuchte nach Anspruch 1, ***dadurch gekennzeichnet,***
**dass** die LED-Leuchte (5) als gegen äussere Einflüsse abgedichtete, insbesondere wasserdichte Einheit ausgebildet ist.

3. LED-Leuchte nach Anspruch 1, ***dadurch gekennzeichnet,***
**dass** mehrere LEDs (6) in einem gemeinsamen Gehäuse (11) oder einer gemeinsamen Ummantelung integriert sind.

4. LED-Leuchte nach Anspruch 3, ***dadurch gekennzeichnet,***
**dass** die mehreren LEDs (6) mit einer gemeinsamen Steuerelektronik ausgerüstet sind und betrieben werden.

5. LED-Leuchte nach mindestens einem der vorhergehenden Ansprüche,
***dadurch gekennzeichnet,***
**dass** die Steuerelektronik zumindest einen Gleichrichter (21) und eine Strombegrenzerschaltung (23) einschliesst.

6. LED-Leuchte nach mindestens einem der vorhergehenden Ansprüche,
***dadurch gekennzeichnet,***
**dass** das Gehäuse (11) und/oder eine das Gehäuse abdichtende Vergussmasse (9) oder die Ummantelung wärmeleitend sind.

7. LED-Leuchte nach mindestens einem der vorhergehenden Ansprüche,
***dadurch gekennzeichnet,***
**dass** die Anschlüsse als Klemmanschlüsse (10) ausgebildet sind.

8. LED-Leuchte nach mindestens einem der Ansprüche 1 bis 6,
***dadurch gekennzeichnet,***
**dass** die Anschlüsse als Kabelanschlüsse (13) ausgebildet sind.

9. LED-Leuchte nach mindestens einem der vorhergehenden Ansprüche,
***dadurch gekennzeichnet,***
**dass** die Trägerplatte (8) auf einer Seite die Steuerelektronik, auf der anderen Seite die LED (6) aufweist.

10. LED-Leuchte nach mindestens einem der vorhergehenden Ansprüche,
***dadurch gekennzeichnet,***
**dass** im Gehäuse (11) eine mechanische Befestigungsvorrichtung vorgesehen ist, in die die Trägerplatte (8) rastbar positioniert werden kann.

11. LED-Leuchte nach Anspruch 10, ***dadurch gekennzeichnet,***
**dass** die mechanische Befestigungsvorrichtung an der Trägerplatte (8) als Sprengring und am Gehäuse (11) als zum Sprengring passende Aussparung, insbesondere als Ringnut, ausgebildet sind.

12. Anordnung mit mehreren LED-Leuchten nach mindestens einem der Ansprüche 1 bis 11, ***dadurch gekennzeichnet,***
**dass** mindestens zwei der LED-Leuchten (5) von einer gemeinsamen Stromversorgungseinheit betrieben werden und vorzugsweise gemeinsam geregelt werden.

13. Anordnung mit mehreren LED-Leuchten nach Anspruch 12, ***dadurch gekennzeichnet,***
**dass** die Stromversorgungseinheit eine Helligkeitsregelung der angeschlossenen LED-Leuchten mittels einer Phasenanschnittregelung der Versorgungsspannung bewirkt.
